# EUROPEAN PATENT SPECIFICATION

(11) **EP 0 584 312 B1**
(45) Date of publication and mention of the grant of the patent: **13.05.1998**
(21) Application number: 93904012.7
(22) Date of filing: 25.02.1993
(51) Int. Cl.: H03F 1/32

(54) **RF POWER AMPLIFIER WITH LINEARIZATTION**
RF Leistungsverstärker mit Linearizierung
AMPLIFICATEUR DE PUISSANCE RF AVEC LINEARISATION

(30) Priority: 02.03.1992 GB 9204497
(43) Date of publication of application: 02.03.1994
(73) Proprietor: MOTOROLA LTD, Basingstoke, Hampshire RG22 4PD (GB)
(72) Inventor: WRAY, Antony John, Hatch Warren, Basingstoke RG22 4LY (GB); VALENTINE, Stephen Thomas, Brighton Hill, Basingstoke RG22 4HR (GB); BRIDLE, Matthew Quinton, Kempshott, Basingstoke RG22 5QG (GB)
(74) Representative: Dunlop, Hugh Christopher
(86) International application number: EP9300430
(87) International publication number: WO9318581

(56) References cited:
- EP-A- 0 253 482
- US-A- 5 066 923
- 40TH IEEE VEHICULAR TECHNOLOGY CONFERENCE 9 May 1990, ORLANDO, FLORIDA pages 35 - 40 , XP203781 FAULKNER ET AL. 'Adaptive Linearisation Using Pre-distortion'
- IEE PROCEEDINGS-H vol. 138, no. 1, February 1991, STEVENAGE, HERTS., GB pages 9 - 12 , XP204587 'Memory controlled feedforward lineariser suitable for MMIC implementation'
- IEEE TRANSACTIONS ON VEHICULAR TECHNOLOGY vol. 39, no. 4, November 1990, NEW YORK, US pages 374 - 382 , XP173256 JAMES K. CAVERS 'Amplifier Linearization Using a Digital Predistorter with Fast Adaptation and Low Memory Requirements'
- IEEE GLOBAL TELECOMMUNICATIONS CONFERENCE vol. 1, 1 December 1986, HOUSTON, TX pages 126 - 132 K. SAM SHANMUGAN ET AL. 'An Adaptive Linearizer for 16-QAM Transmission over Non-linear Satellite Channels'
- 41TH VEHICULAR TECHNOLOGY CONFERENCE 19 May 1991, ST. LOUIS, MO pages 753 - 758 , XP260272 S.P.STAPLETON ET AL. 'A New Technique for Adaptation og Linearizing Predistorters'

## Description

### Field of the Invention

This invention relates to a radio frequency power amplifier employing a linearization technique.

### Background of the Invention

Future mobile radio systems will be required to improve their spectral efficiency beyond that which currently exists today. This will mean that modulation schemes in which the information is carried in both the transmitted signal amplitude and phase will increasingly become required. In order to conserve spectrum and to coexist with current radio systems the transmitters using these complex modulations will have to be linear. For example adjacent channel interference levels of > -60dBc in a 25kHz channelisation may be required.

### Summary of the Prior Art

One technique to achieve such power amplifier linearity performance is Cartesian feedback. This technique has become popular as it lends itself to integration on IC's.

The requirement for linearity (determined by adjacent channel interference limits) and maximum power efficiency, means that the power amplifier will have to operate as close to the gain compression (clip) point as possible, but still retain required level of linearity.

A known technique to measure and adjust for maximum phase margin of the closed loop system and to identify the clip point of the amplifier uses an appropriate training sequence. Gain compression is detected by an increase in the magnitude of the Cartesian loop error signal above a given threshold. At this point the drive level control circuits are set appropriately and linear operation is assured - i.e. input signal is backed off.

The above technique is only suitable in future radio products where time is available for training prior to each transmission. Time delays generally required to implement training are in the order of milliseconds. To allow this linearization technique to be implemented in systems where no training time is allocated, an alternative approach is required.

In addition to achieving linearity through training, there is a need for improved methods of maintaining linearity.

### Summary of the Invention

According to a first aspect of the present invention as defined in the appended claims, there is provided a radio transmitter comprising: a power amplifier; a lineariser circuit for compensating for nonlinearity in the power amplifier; and a feedback circuit for feeding a signal from an output of the power amplifier to the lineariser circuit for maintaining linearity, said amplifier, lineariser circuit and feedback circuit forming a loop having adjustable loop linearization parameters; a look-up table for storing predetermined loop linearisation parameters and a linear controller having an operating condition input, said linear controller being coupled to the look-up table and the loop for selecting a loop linearisation parameter in response to a transmit control signal according to an operating condition input to the linear controller at the time of receipt of the transmit control signal.

The loop linearisation parameters may be phase and/or gain parameters.

The operating condition input may be channel frequency, battery level, temperature or other information. A separate table may be stored for different values for each of these parameters. Thus, when operating at half the battery level, a table may be selected relating to that battery level.

There is preferably a temperature input receiving a signal from a temperature sensor.

The tables preferably have settings for both phase and gain parameters.

In a particularly preferred feature of the invention, the look-up table is updated by measuring the actual loop linearisation parameter, selecting an improved linearisation parameter and writing the improved parameter into the look-up table. In this manner, the accuracy of the look-up tables can be maintained with time. Moreover, by continuously updating the look-up tables, it is not necessary to store as extensive a range of linearization parameters for different operating conditions.

A phase setting is particularly sensitive to changes in operating conditions and the look-up tables may contain more phase parameter information than gain parameter information. In particular, if the phase margin can always be maintained at a maximum level, reduced adjacent channel splatter is observed.

In a second aspect of the present invention as defined in the appended claims a radio transceiver is provided comprising: a power amplifier coupled to an antenna for transmission of radio signals on a transmit channel; a lineariser circuit for compensating for nonlinearity in the power amplifier; a microprocessor; a first feedback circuit operably coupled to an output of the power amplifier for feeding a portion of a transmit radio signal from the output of the power amplifier to the lineariser circuit to adjust the lineariser circuit, said lineariser circuit, said power amplifier and said first feedback circuit forming a real-time feedback loop of the transmit radio signal for maintaining linearity of the transmit radio signal. The radio transceiver is characterised by: a second feedback circuit (a or b) operably coupled to an output of the power amplifier for feeding a portion of the transmit radio signal from the output of the power amplifier to an adjacent channel receiver for measuring signals from the power amplifier appearing on at least one of transmit adjacent channel and wherein the microprocessor further adjusts the lineariser circuit in response to signals measured on the at least one transmit adjacent channel.

A preferred embodiment of the invention will now be described, by way of example only, with reference to the drawings.

### Brief Description of the Drawings

Fig. 1 shows a block diagram of a radio transmitter with power amplifier and linearizer in accordance with a first embodiment of the invention.

Fig. 2 shows a block diagram of a radio transmitter with power amplifier and linearizer in accordance with a second embodiment of the invention.

Fig. 3 shows switched attenuator circuit for switching into the circuit of Fig. 2 at point (b).

Fig. 4 shows a TDMA timing format in which the invention may be employed.

### Detailed Descriptions of the Preferred Embodiments

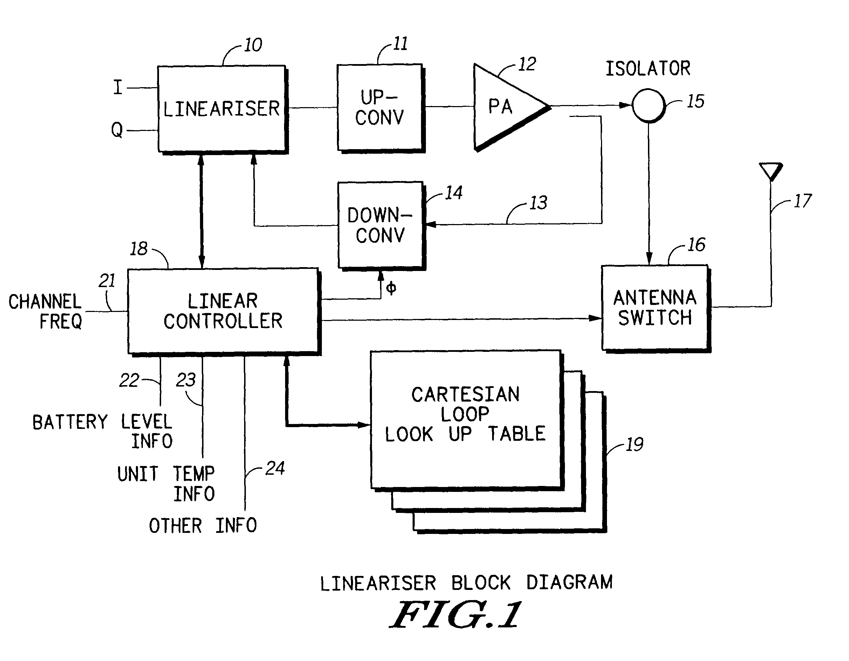

Referring to Fig. 1, there is shown a radio transmitter comprising a linearizer 10, an upconverter 11, a power amplifier 12, a feedback loop 13, and a downconverter 14. The output of the power amplifier 12 is connected via an isolator 15 and an antenna switch 16 to an antenna 17. A linear controller 18 is provided connected to the linearizer 10, the downconverter 14 and the antenna switch 16. Connected to the linear controller 18 is a series of look-up tables in memory 19. The linear controller 18 has a number of inputs of which a channel/frequency input 21, a battery level input 22, a unit temperature input 23 and other information inputs 24 are shown.

On accepting a request for transmission from a push-to-talk (PTT) switch (not shown) or otherwise, the transmitter power amplifier 12 is turned on. The various operating parameter inputs 21, 22 and 23 are measured by the controller 18 and a look-up table 19 is selected for the measured conditions. Thus, for a particular channel, battery level and measured temperature (as indicated by a temperature sensor), predetermined gain and phase settings will be downloaded from the look-up table 19.

The linearizer phase shift and drive level attenuator settings, which are described in more detail in the paper "Transmitter Linearization using Cartesian Feedback for Linear TDMA Modulation" by M Johansson and T Mattsson 1991, IEEE are set in the downconverter 14 and the linearizer 10 respectively by the linear controller 18 depending on the values read from the look-up table 19. The antenna switch 16 is at this point operated using an appropriately controlled ramp signal, having a raised cosine profile, to avoid excess splatter to adjacent channels. Transmission of the information (data or voice) defined by I and Q samples input to the linearizer 10 now takes place in a stable linear operation.

The values in the look-up table 19 are set in the factory by extensive testing at different temperatures battery levels, etc.

In a more preferred embodiment of the invention, the values in the look-up table are updated as the radio is used.

For a given transmission request, the loop phase and gain parameters read from the look-up table 19 are those set in the look-up table from a previous transmission on the channel in question at the battery level and temperature in question. When these values have been loaded into the linearizer 10 and transmission begins, a comparison is made between the I and Q values input and those received on the feedback loop 13 from the downconverter 14. Based on a comparison of these values, a decision is made as to the need for updating the loop phase and gain parameters. If, for example, the phase margin has decreased, a new phase setting is calculated to increase the phase margin for the loop. This new phase setting is now written into the particular location in the look-up table 19 for the current channel, battery level and temperature settings and replaces the previously existing value. The new value will be used next time a transmission is requested on that channel at that battery level and at that temperature.

An assumption is made that changes in loop phase and gain characteristics due to battery voltage and temperature are independent of one another. This allows separate look-up tables to be used for different battery voltage settings and temperature settings. It is found that this is a workable assumption, however, more extensive look-up tables can be stored for particular battery level and temperature pairs. The memory 19 can be arranged in other formats. Interpollation may be carried out between values, e.g. values for measurements at two temperature when the temperature sensor senses an intermediate temperature.

To allow for the linearizer adjustment, the ramp signal to the antenna switch is delayed by an appropriate amount At; this is to compensate for the look-up table access time and downloaded to the linearizer circuitry. This delay is assumed to be minimal in comparison with the ramp time of the antenna switch. Therefore when the antenna is connected to the power amplifier output, the power amplifier is operating at the correct level to ensure compliance with required interference specifications.

As an alternative to sensing of loop gain and phase settings and refreshing the look-up table entries after each transmission, a retraining sequence can be input to the linearizer 10 and transmitted out of the antenna 17, or into a load as described in granted UK patent GB 2265269 entitled "Radio Transmitter with Linearization Training Sequence" filed on the same date as the present application, or transmitted into an adjacent channel receiver as is described below.

The sensing of loop gain and phase settings and refreshing of the look-up table entries after each transmission does not incur a time penalty and allows the transmitter to be available at all times. The values in the tables can be refreshed when a measured value deviates from a stored value by more than the predetermined amount, or they can be refreshed at regular intervals.

If retraining is used, this can be implemented by refreshing the look-up table entries on every power-up of the radio, by refreshing the look-up table entries at fixed intervals of operation in terms of absolute time or transmission time, or refreshing the look-up table entries at intervals dictated by radio transmitter conditions.

Loop phase and drive level settings are monitored and adjusted during transmission to take into account changing device characteristics and the linearized power amplifier is optimized for both stability and efficiency. The transmitter efficiency is maximized by operating the power amplifier as close to its gain compression point as possible, as described in US Patent Application No. 606679 of Motorola Inc, annexed hereto as "Annex 1" The transmitter, however, is restricted by the amount of adjacent channel interference it should be allowed to generate. For maximum efficiency the transmitter must operate as close to the adjacent channel interference limit as possible. It would be desirable to provide an improved means for performing a "clip detect" operation to find the optimum setting of loop gain for the feedback network.

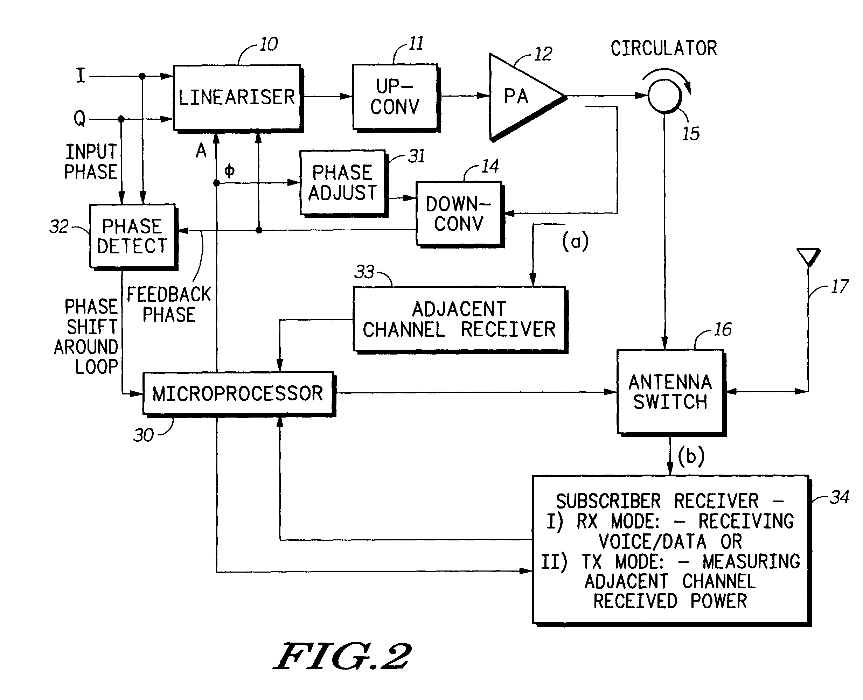

An arrangement is shown in Fig. 2 which meets the above need and comprises a number of elements already described with reference to Fig. 1. In Fig. 2, there is shown a microprocessor 30 which controls the gain (A) and phase (ø) of the feedback loop. In Fig. 2, a phase adjuster 31 is shown separate to the linearizer 10, as is a feedback phase detector 32. It will be appreciated that these elements are present in the circuit of Fig. 1, but are merely encompassed within the linearizer block 10 of Fig. 1.

In addition to the above elements, the circuit of Fig. 2 has an adjacent channel receiver 33, or in a further embodiment, as an alternative to adjacent channel receiver 33, a subscriber receiver 34 is provided with a control input from microprocessor 30 for changing the receive frequency of the subscriber receiver 34 from a receive mode (for receiving voice/data from the antenna 17) to an adjacent channel receive mode for measuring adjacent channel receive power.

Referring to the first of these alternative embodiments, the adjacent channel receiver 33 is connected to the output of the power amplifier 12 and comprises an attenuator, a downconverter to a suitable IF frequency, a mixer which taps a signal from a main synthesizer for the radio, an IF filter, an attenuator, a rectifier and means for measuring voltage across the rectifier. A ceramic filter is suitable for the IF filter. This ceramic filter is a 25 KHz bandpass filter tuned to a frequency 25KHz offset from the IF signal for the corresponding transmit channel.

In the second embodiment shown in Fig. 2 in which the subscriber receiver 34 changes between a receive mode and an adjacent channel receive mode, operation will be described with reference to a TDMA system having 60 millisecond frames divided into 4 timeslots of 15 milliseconds each as shown in Fig. 4. A transmit frame is always offset from a receive frame and vice versa. A channel pair may comprise the first timeslot of the transmit frame and the first timeslot of the receive frame or the second timeslot of the transmit frame and the second timeslot of the receive frame etc. There will always be about 15 milliseconds between the end of a transmit timeslot and the beginning of a receive timeslot. This provides ample time for the microprocessor 30 to provide a control signal to the synthesizer of the subscriber receiver 34 to cause a receive frequency change equal to the duplex frequency separation between the transmission receive frequencies less (or in addition to) an amount equal to the channel spacing. Where the duplex frequency separation is 10MHz, and the channel separation is 25 KHz, the signal from the microprocessor causes the receiver 34 to change its receive frequency through 9.975 MHz or 10.025 MHz. After a receive frame, the receiver 34 changes its frequency to be adjacent that of the signal being transmitted from power amplifier 12 in a transmit frame and, after transmission, it switches back to its appropriate receive frequency for receiving the next timeslot from the antenna 17.

While the adjacent channel receiver 33 or the re-tuned subscriber receiver 34 is tuned to the adjacent channel, it is able to measure the power on the adjacent channel. If the level of signal on the adjacent channel exceeds a threshold, for example a threshold of 60 or 63 dB below the output level of the power amplifier 12, this is an indication of onset of clipping in the power amplifier 12 and an indication that it is necessary to back off the gain of the power amplifier 12. Thus, the adjacent channel receiver 33 or the subscriber receiver 34 provides a signal to the microprocessor 30 from which, if onset of clipping is detected, controls the linearizer 10 to reduce the gain A.

As a result, with a real-time knowledge of the splatter to adjacent channel power, backing off made to the drive level to the power amplifier can be minimised at all times ensuring true optimum operating efficiency. In addition, the arrangement ensures a predetermined maximum splatter into the adjacent channel at all times.

On detecting of clipping and backing off of the power amplifier, the new value for the loop gain (a) can be loaded into the look-up tables of Fig. 1.

The adjacent channel receiver of 33 or subscriber receiver 34 can be used for detecting "clip" during a training sequence such as that described in US Patent No. 5066923 of Motorola Inc. During the training sequence, the energy of the power amplifier is diverted into the adjacent channel receiver 33 or the subscriber receiver 34 by isolation of the antenna 17 using the antenna switch 16. This allows the energy to be directed away from the antenna ensuring "off-air" training and no on-air adjacent channel splatter. It is proposed that this transmit energy whilst training is diverted into the appropriate receiver by the microprocessor 30 controlling the antenna switch 16. This can be achieved by:
(1) coupling of some of the feedback signal power into a separate receiver tuned to the adjacent channel or
(2) short circuiting the antenna switch into the subscriber unit receiver and switching the down-converter local oscillator frequency by the duplex separation frequency plus or minus the channel bandwidth, therefore allowing the standard receiver to perform a received signal strength indication on the adjacent transmit channel.

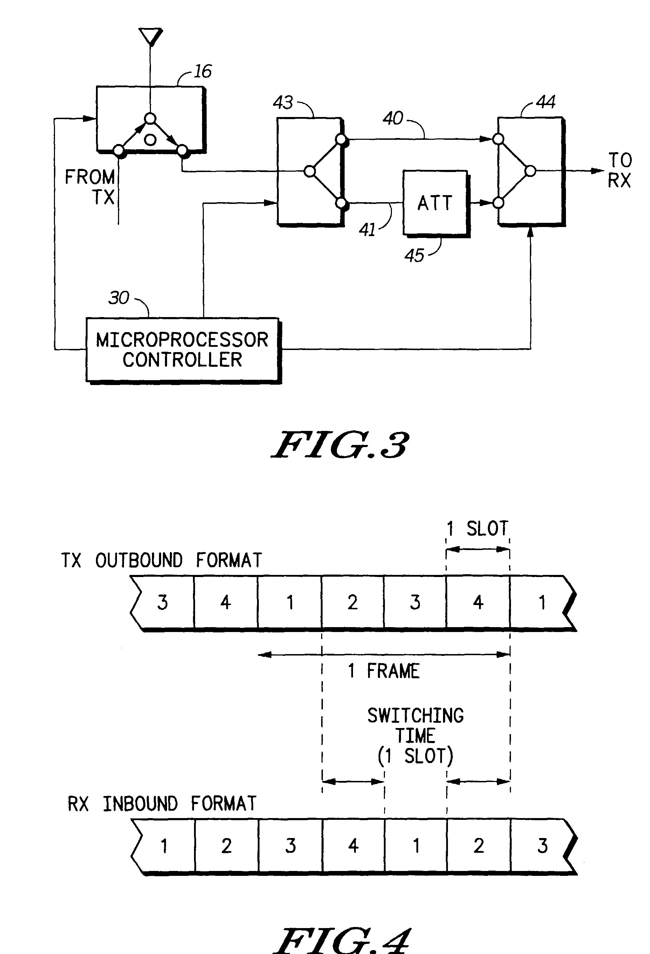

In the case of a short circuited implementation, suitable attenuation of the transmitter power is required to avoid over driving the receiver. This is implemented by appropriate switching of receiver paths 40 and 41 as shown in Fig. 3. Receiver path 40 provides a path from the antenna 17 to the receiver 34. Adjacent channel receive path 41 provides a path in the case of routing of the signal from the power amplifier 12 to the receiver 34. The circuit comprises three pin diode switches 16, 43 and 44 under control of the microprocessor 30. An attenuator 45 is provided in the adjacent channel receive path 41, having a suitable value to avoid overdriving the receiver circuitry. The operation is as follows. Simultaneously with the switching of the antenna switch 16 by the microprocessor controller 30, the controller 30 causes pin diode switches 43 and 44 to switch from path 40 to path 41, thus switching attenuator 45 into the path to protect the receiver. The timing can be arranged such that attenuator 45 is always switched into the path before antenna switch 16 switches

The measurement of the adjacent channel power in the adjacent channel receiver can be accomplished by any of the standard methods available. One of which is to use an FFT of the received signal, and then processing this data to obtain a measurement of the adjacent channel power. The generation of the transmit spectrum has the advantage over the previously described method of using the a separate adjacent channel receiver for measuring the adjacent channel power as it is able to monitor both adjacent channels simultaneously.

The invention also allows a method of real-time monitoring of the phase shift around the feedback loop, thus allowing the loop phase to be adjusted whenever required, ensuring stability at all times. This technique can be utilised to reduce the phase margin normally designed into such feedback systems, therefore creating an opportunity to increase the loop gain and consequently improve the intermodulation performance that is attainable by significant amount.

It is proposed that some of the feed-back signal is routed into a phase detector, which then transmits the phase information of the feed-back signal to the microprocessor. This phase measurement can then be compared against the phase of the transmitted signal (which is also measured). Any transmit data is suitable for use with this phase comparison. It is suggested that for continuous operation mode within current TDMA frame structures, that measuring the phase shift of the synchronisation word is a good option.

Phase shift measurement during the synchronisation word is carried out at the beginning of a timeslot when the synchronisation work is transmitted in terms of predetermined I and Q samples being input to linearizer 10. These predetermined I and Q samples can be used for comparison with the corresponding samples measured by downconverter 14. Thus, the phase shift measurement is carried out during transmission of the synchronisation word.

The overall arrangement described provides the advantages of:
(1) providing a method of "clip detection" by measuring the splattered power transmitted into the adjacent channel as part of a training process or as a real-time measurement of the intermodulation performance of the loop:
(2) providing an alternative method of measuring the phase shift around the feedback loop during continuous operation and during a training process and
(3) maximising the operating efficiency of the power amplifier by operating as close as possible to its saturation level whilst maintaining a satisfactory intermodulation ratio performance.

Instead of using Cartesian feedback, predistortion feedback can be used as described in the paper "Linear Amplification Technique for Digital Mark Communications" by Yoshinori Nagata 1989 IEEE. In this case parameters other than gain and phase will be stored in the look-up table. Instead, I and Q sample predistortion factors or parameters will be stored.

## Claims

1. A radio transmitter circuit comprising:
a power amplifier (12) coupled to an antenna (17) for transmission of radio signals on a transmit channel;
a lineariser circuit (10) for compensating for nonlinearity in the power amplifier (12);
a feedback circuit (13) for feeding a signal from an output of the power amplifier (12) to the lineariser circuit (10) for maintaining linearity of said power amplifier (12), lineariser circuit (10) and feedback circuit (13) forming a loop having adjustable loop linearisation parameters; the radio transmitter circuit characterised by:
a look-up table (19) for storing loop linearisation parameters; and
a linear controller (18) having an operating condition input (21, 22, 23 or 24), said linear controller (18) being coupled to the look-up table (19) and the loop for selecting at least one loop linearisation parameter in response to a transmit control signal according to an operating condition input (21, 22, 23 or 24) to the linear controller (18) at the time of receipt of the transmit control signal.

2. The radio transmitter circuit according to claim 1, further characterised in that the operating condition input (21, 22, 23 or 24) is coupled to at least one sensor for sensing at least one of frequency, battery level and temperature.

3. The radio transmitter circuit according to claims 1 or 2, wherein the loop linearisation parameters are preprogrammed.

4. The radio transmitter circuit according to claims 1 or 2 further characterised by means for monitoring (18) at least one actual loop linearisation parameter, means for selecting (18) at least one improved linearisation parameter and means for writing (18) the at least one improved loop linearisation parameter into the look-up table (19).

5. The radio transmitter circuit according to claim 4, wherein the at least one improved loop linearisation parameter is written into the look-up table (19) with a corresponding operating condition input (21, 22, 23 or 24), provided by the at least one sensor.

6. The radio transmitter circuit according to claim 5, characterised in that the linear controller (18) inputs a training sequence into the lineariser circuit (10), the means for monitoring (18) monitors the at least one actual loop linearisation parameters in response to the training sequence and the means for selecting (18) selects at least one improved linearisation parameter in response to the monitoring.

7. The radio transmitter circuit according to claim 6, characterised in that the training sequence is a synchronisation word used for lineariser training and for timing synchronisation when transmitting to radios.

8. The radio transmitter circuit according to any of the preceding claims, wherein the at least one loop linearisation parameters include at least one of the following: amplitude settings, phase settings.

9. A radio transceiver comprising:
a power amplifier (12) coupled to an antenna (17) for transmission of radio signals on a transmit channel;
a lineariser circuit (10) for compensating for nonlinearity in the power amplifier (12);
a microprocessor (30);
a first feedback circuit operably coupled to an output of the power amplifier (12) for feeding a portion of a transmit radio signal from the output of the power amplifier (12) to the lineariser circuit (10) to adjust the lineariser circuit (10), said lineariser circuit (10), said power amplifier (12) and said first feedback circuit forming a real-time feedback loop of the transmit radio signal for maintaining linearity of the transmit radio signal; the radio transceiver characterised by:
a second feedback circuit (a or b) operably coupled to an output of the power amplifier (12) for feeding a portion of the transmit radio signal from the output of the power amplifier (12) to an adjacent channel receiver (33 or 34) for measuring signals from the power amplifier (12) appearing on at least one of transmit adjacent channel and wherein the microprocessor (30) further adjusts the lineariser circuit (10) in response to signals measured on the at least one transmit adjacent channel.

10. The radio transceiver of claim 9, wherein the radio transceiver includes a transmitter circuit comprising the power amplifier (12) operably coupled via the first feedback circuit to the lineariser circuit (10), and operably coupled via the second feedback circuit and the adjacent channel receiver (33 or 34) to the lineariser circuit (10).

11. The radio transceiver of claims 9 or 10, wherein the radio transceiver includes a transmitter circuit comprising:
the power amplifier (12) operably coupled via the first feedback circuit to the lineariser circuit (10); and
the radio transceiver characterised in that:
a dual mode receiver circuit (34) is operably coupled to an antenna (17) for receiving radio signals on a receive frequency in a first mode of operation, and is operably coupled to the power amplifier (12) and the lineariser circuit (10) via the second feedback circuit for operating as the adjacent channel receiver to receive transmit radio signals from the power amplifier (12) on the at least one transmit adjacent channel in a second mode of operation.

12. The radio transceiver of claim 11, further characterised in that an antenna switch (16) is operably coupled between an antenna (17), the transmitter circuit and the dual mode receiver circuit (34), wherein operation of the dual mode receiver circuit is selectively switchable at the antenna switch (16), between the receive frequency and the at least one transmit adjacent channel, by the microprocessor (30).

13. The radio transceiver of claims 11 or 12, further characterised in that the microprocessor (30) switches operation of the dual mode receiver circuit (34) between a receive frequency on a receive timeslot and an adjacent channel frequency on a transmit channel and back to the receive frequency on a subsequent receive timeslot.

14. The radio transceiver according to claims 11, 12 or 13, wherein the dual mode receiver circuit (34) is further characterised by a selectable attenuator circuit (45), switchable into a path between the power amplifier (12) and the dual mode receiver circuit (34) for attenuating the signal from the power amplifier (12) in the second mode of operation and for passing an unattenuated signal from the antenna (17) to the dual mode receiver (34) during the second mode of operation.

15. The radio transceiver according to any of claims 9 to 14, further characterised in that the microprocessor (30) outputs a training sequence to the lineariser circuit (10) and wherein the first feedback circuit feeds the training sequence output from the power amplifier (12) back to the lineariser circuit (10) to monitor loop linearisation parameters and feeds the training sequence output from the power amplifier (12) back to the adjacent channel receiver (33 or 34) to monitor transmit signals in the at least one transmit adjacent channels; the microprocessor (30) selecting at least one improved loop linearization parameter in response to the monitored loop linearisation parameters or signals in the at least one transmit adjacent channels.

16. The radio transceiver according to any of claims 9 to 15, wherein the radio transceiver further characterised by means for transmitting a synchronisation sequence for providing timing information to a receiving radio and means for using the synchronisation sequence as a training sequence and training to the synchronisation sequence.

17. The radio transceiver according to any of claims 9 to 16, further ccharacterised by:
a look-up table (19) for storing predetermined loop linearization parameters; and
a controller (18) having an operating condition input, said controller (18) being coupled to the look-up table (19) and the first feedback loop for selecting a loop linearization parameter in response to a transmit control signal according to an operating condition input (21, 22, 23 or 24) to the controller (18).

18. The radio transceiver according to claim 17, wherein the operating condition input (21, 22, 23 or 24) is coupled to sensing means for sensing at least one of frequency, battery level and temperature, the loop linearization parameters including at least one of the following: loop phase parameters and loop gain parameters.

19. The radio transceiver according to claim 17 or 18, wherein the microprocessor (30) monitors the actual loop linearization parameter, selects an improved linearization parameter and writes the improved loop linearization parameter into the look-up table (19).

20. The radio transceiver according to any of claims 9 to 19, wherein the adjacent channel receiver (33 or 34) performs a fast fourier transform on the transmit signal, to provide adjacent channel information for both transmit adjacent channels.

## Patentansprüche

1. Funkübertragungsschaltung, die folgendes umfaßt:
• einen Leistungsverstärker (12), der an eine Antenne (17) geschaltet ist zur Übertragung von Funksignalen auf einem Übertragungskanal;
• eine Linearisierungsschaltung (10) zum Ausgleich von Nichtlinearität im Leistungsverstärker (12);
• eine Rückkopplungsschaltung (13) zur Führung eines Signals von einem Ausgang des Leistungsverstärker (12) zur Linearisierungsschaltung (10) zur Aufrechterhaltung der Linearität dieses Leistungsverstärker (12), wobei die Linearisierungsschaltung (10) und die Rückkopplungsschaltung (13) eine Schleife bilden, die einstellbare Schleifenlinearisierungsparameter hat;
wobei die Funkübertragungsschaltung gekennzeichnet ist durch:
• eine Verweistabelle (19) zum Speichern der Schleifenlinearisierungsparameter; und
• eine lineare Steuereinheit (18), die einen Betriebsbedingungseingang (21, 22, 23 oder 24) hat, wobei diese lineare Steuereinheit (18) an die Verweistabelle (19) und die Schleife geschaltet ist zur Auswahl zumindest eines Schleifenlinearisierungsparameters in Reaktion auf ein Übertragungssteuersignal entsprechend eines Betriebsbedingungseingangs (21, 22, 23 oder 24) in die lineare Steuereinheit (18) zum Zeitpunkt des Empfangs des Übertragungssteuersignals.

2. Funkübertragungsschaltung nach Anspruch 1, weiter dadurch gekennzeichnet, daß der Betriebsbedingungseingang (21, 22, 23 oder 24) an zumindest einen Meßfühler geschaltet ist zum Erfassen von zumindest einer Größe von Frequenz, batteriepegel und Temperatur.

3. Funkübertragungsschaltung nach Anspruch 1 oder 2, wobei die Schleifenlinearisierungsparameter vorprogrammiert sind.

4. Funkübertragungsschaltung nach Anspruch 1 oder 2, weiter gekennzeichnet durch Mittel zur Überwachung (18) zumindest eines aktuellen Schleifenlinearisierungsparameters, Mittel zur Auswahl (18) zumindest eines verbesserten Schleifenlinearisierungsparameters und Mittel zum Schreiben (18) zumindest eines verbesserten Schleifenlinearisierungsparameters in die Verweistabelle (19).

5. Funkübertragungsschaltung nach Anspruch 4, wobei der zumindest eine verbesserte Schleifenlinearisierungsparameter in die Verweistabelle (19) geschrieben wird mit einer entsprechenden Betriebsbedingungseingabe (21, 22, 23 oder 24), die durch zumindest einen Meßfühler geliefert wird.

6. Funkübertragungsschaltung nach Anspruch 5, dadurch gekennzeichnet, daß die lineare Steuereinheit (18) eine Formierungsfolge in die Linearisierungsschaltung (10) eingibt, wobei die Mittel zur Überwachung (18) den zumindest einen aktuellen Schleifenlinearisierungsparameter in Reaktion auf die Formierungsfolge überwachen und die Mittel zur Auswahl (18) zumindest einen verbesserten Linearisierungsparameter in Reaktion auf die Überwachung auswählen.

7. Funkübertragungsschaltung nach Anspruch 6, gekennzeichnet dadurch, daß die Formierungsfolge ein Synchronisationswort ist, das zur Formierung der Linearisierungseinrichtung und zur Synchronisation des zeitlichen Ablaufs benutzt wird, wenn zu den Funkgeräten übertragen wird.

8. Funkübertragungsschaltung nach einem der vorhergehenden Ansprüche, wobei der zumindest eine Schleifenlinearisierungsparameter zumindest eine der folgenden Größen enthält: Amplitudeneinstellungen, Phaseneinstellungen.

9. Funksendeempfänger, der folgendes umfaßt:
• einen Leistungsverstärker (12), der an eine Antenne (17) geschaltet ist zur Übertragung von Funksignalen auf einem Übertragungskanal;
• eine Linearisierungsschaltung (10) zum Ausgleich von Nichtlinearität im Leistungsverstärker (12);
• ein Mikroprozessor (30);
• eine erste Rückkopplungsschaltung, bedienbar an einen Ausgang des Leistungsverstärker (12) geschaltet zur Führung eines Anteils eines Übertragungsfunksignals vom Ausgang des Leistungsverstärkers (12) zur Linearisierungsschaltung (10), um die Linearisierungsschaltung (10) abzustimmen, wobei diese Linearisierungsschaltung (10), dieser Leistungsverstärker (12) und diese erste Rückkopplungsschaltung eine Echtzeitrückkopplungsschleife des Übertragungsfunksignals zur Aufrechterhaltung der Linearität des Übertragungsfunksignals bilden;
wobei der Funksendeempfänger gekennzeichnet ist durch:
• eine zweite Rückkopplungsschaltung (a oder b), bedienbar an einen Ausgang des Leistungsverstärker (12) geschaltet zur Führung eines Anteils des Übertragungsfunksignals vom Ausgang des Leistungsverstärkers (12) zu einem Nachbarkanalempfänger (33 oder 34) zur Messung der Signale vom Leistungsverstärker (12), die auf zumindest einem Übertragungsnachbarkanal erscheinen, und wobei der Mikroprozessor (30) weiterhin die Linearisietiigsschaltung (10) in Reaktion auf die Signale, die auf dem zumindest einem Übertragungsnachbarkanal gemessen werden, abstimmt.

10. Funksendeempfänger nach Anspruch 9, wobei der FunKsendeempfänger eine Übertragungsschaltung beinhaltet, die den Leistungsverstärker (12) umfaßt, der bedienbar über die erste Rückkopplungsschaltung an die Linearisierungsschaltung (10) geschaltet ist, und bedienbar über die zweite Rückkopplungsschaltung und den Nachbarkanalempfänger (33 oder 34) an die Linearisierungsschaltung (10) geschaltet ist.

11. Funksendeempfänger nach Anspruch 9 oder 10, wobei der Funksendeempfänger eine Übertragungsschaltung beinhaltet, umfassend:
• den Leistungsverstärker (12), der bedienbar über die erste Rückkopplungsschaltung an die Linearisierungsschaltung (10) geschaltet ist; und
wobei der Funksendeempfänger, dadurch gekennzeichnet ist, daß:
• eine Doppelmodusempfängerschaltung (34) bedienbar an eine Antenne (17) geschaltet ist zum Empfang von Funksignalen auf einer Empfangs frequenz in einer ersten Betriebsweise, und bedienbar an den Leistungsverstärker (12) und die Linearisierungsschaltung (10) über die zweite Rückkopplungsschaltung geschaltet ist zum Betrieb als Nachbarkanalempfänger, um Übertragungsfunksignale vom Leistungsverstärker (12) auf zumindest einem Übertragungsnachbarkanal in einer zweiten Betriebsweise zu empfangen.

12. Funksendeempfänger nach Anspruch 11, weiter dadurch gekennzeichnet, daß ein Antennenumschalter (16) bedienbar zwischen eine Antenne (17), die Übertragungsschaltung und die Doppelmodusempfängerschaltung (34) geschaltet ist, wobei der Betrieb der Doppelmodusempfängerschaltung am Antennenumschalter (16) durch den Mikroprozessor (30) selektiv umschaltbar ist zwischen der Empfangsfrequenz und dem zumindest einem Übertragungsnachbarkanal.

13. Funksendeempfänger nach Anspruch 11 oder 12, weiter dadurch gekennzeichnet, daß der Mikroprozessor (30) die Betriebsweise der Doppelmodusempfängerschaltung (34) zwischen einer Empfangs frequenz in einem Empfangszeitabschnitt und einer Nachbarkanalfrequenz auf einem Übertragungskanal und zurück zur Empfangs frequenz in einem nachfolgendem Empfangszeitabschnitt schaltet.

14. Funksendeempfänger nach Anspruch 11, 12 oder 13, wobei die Doppelmodusempfängerschaltung (34) weiter gekennzeichnet ist durch eine auswählbare Dämpfungsschaltung (45), die in den Pfad zwischen den Leistungsverstärker (12) und die Doppelmodusempfängerschaltung (34) schaltbar ist zur Dämpfung des Signals vom Leistungsverstärker (12) in der zweiten Betriebsweise und zur Übergabe eines ungedämpften Signals von der Antenne (17) an den Doppelmodusempfänger (34) während der zweiten Betriebsweise.

15. Funksendeempfänger nach einem der Ansprüche 9 bis 14, weiter dadurch gekennzeichnet, daß der Mikroprozessor (30) eine Formierungsfclge an die Linearisierungsschaltung (10) ausgibt, und wobei die erste Rückkopplungsschaltung den Formierungsfolgenausgang vom Leistungsverstärker (12) zurück zur Linearisierungsschaltung (10) führt, um die Schleifenlinearisierungsparameter zu überwachen, und den Formierungsfolgenausgang vom Leistungsverstärker (12) zurück zum Nachbarkanalempfänger (33 oder 34) führt, um die Übertragungssignale auf dem zumindest einen Übertragungsnachbarkanal zu überwachen; wobei der Mikroprozessor (30) zumindest einen verbesserten Schleifenlinearisierungsparameter auswählt in Reaktion auf die überwachten Schleifenlinearinierungsparameter oder die Signale auf dem zumindest einen Übertragungsnachbarkanal.

16. Funksendeempfänger nach einem der Ansprüche 9 bis 15, wobei der Funksendeempfänger weiter gekennzeichnet ist durch Mittel zur Übertragung einer Synchronisationsfolge zur Bereitstellung von Zeitablaufinformationen an ein empfangendes Funkgerät und Mittel zur Verwendung der Synchronisationsfolge als eine Formierungsfolge und zur Formierung der Synchronisationsfolge.

17. Funksendeempfänger nach einem der Ansprüche 9 bis 16, weiter gekennzeichnet durch:
• eine Verweistabelle (19) zur Speicherung der vorbestimmten Schleifenlinearisierungsparameter; und
• eine Steuereinheit (18), die einen Arbeitsbedingungseingang hat, wobei diese Steuereinheit (18) an die Verweistabelle (19) und die erste Rückkopplungsschleife geschaltet ist zur Auswahl eines Schleifenlinearisierungsparameter in Reaktion auf ein Übertragungssteuersignal entsprechend eines Arbeitsbedingungseingangs (21, 22, 23 oder 24) in die Steuereinheit (18).

18. Funksendeempfänger nach Anspruch 17, wobei der Arbeitsbedingungseingang (21, 22, 23 oder 24) an die Erfassungsmittel geschaltet ist zur Erfassung zumindest einer Größe von Frequenz, Batteriepegel und Temperatur, wobei der Schleifenlinearisierungsparameter zumindest eine der folgenden Größen beinhaltet: Schleifenphasenparameter und Schleifenverstärkungsparameter.

19. Funksendeempfänger nach Anspruch 17 oder 18, wobei der Mikroprozessor (30) die aktuellen Schleifenlinearisierungsparameter überwacht, einen verbesserten Schleifenlinearisierungsparameter auswählt und den verbesserten Schleifenlinearisierungsparameter in die Verweistabelle (19) schreibt.

20. Funksendeempfänger nach einem der Ansprüche 9 bis 19, wobei der Nachbarkanalempfänger (33 oder 34) eine schnelle Fourier Transformation des Übertragungssignals ausführt, um die Nachbarkanalinformationen, für beide Übertragungsnachbarkanäle zu liefern.

## Revendications

1. Circuit émetteur radio comprenant :
un amplificateur de puissance (12) couplé à une antenne (17) pour la transmission de signaux radio sur un canal de transmission ;
un circuit linéariseur (10) pour compenser l'absence de linéarité de l'amplificateur de puissance (12) ;
un circuit de contre-réaction (13) pour alimenter un signal entre une sortie de l'amplificateur de puissance (12) et le circuit linéariseur (10) pour maintenir la linéarité dudit amplificateur de puissance (12), le circuit linéariseur (10) et le circuit de contre-réaction (13) formant une boucle ayant des paramètres de linéarisation de boucle réglables ;
le circuit émetteur radio étant caractérisé par :
une table de recherche (19) pour mémoriser les paramètres de linéarisation de boucle ; et
un régulateur linéaire (18) ayant une entrée d'état de fonctionnement (21, 22, 23 ou 24), ledit régulateur linéaire (18) étant couplé à la table de recherche (19) et à la boucle pour sélectionner un paramètre de linéarisation de boucle en réponse à un signal de commande de transmission selon une entrée d'état de fonctionnement (21, 22, 23 ou 24) au régulateur linéaire (18) au moment de la réception du signal de commande de transmission.

2. Circuit émetteur radio selon la revendication 1, caractérisé en outre en ce que l'entrée d'état de fonctionnement (21, 22, 23 ou 24) est couplée à au moins un détecteur pour détecter au moins l'un parmi la fréquence, le niveau de batterie et la température.

3. Circuit émetteur radio selon les revendications 1 ou 2, dans lequel les paramètres de linéarisation de la boucle sont préprogrammés.

4. Circuit émetteur radio selon les revendications 1 ou 2, caractérisé en outre par un moyen de surveillance (18) au moins un paramètre de linéarisation de boucle réel, un moyen de sélection (18) d'au moins un paramètre de linéarisation amélioré et un moyen d'écriture (18) du paramètre de linéarisation de boucle amélioré, au nombre d'au moins un, dans la table de recherche (19).

5. Circuit émetteur radio selon la revendication 4, dans lequel le paramètre de linéarisation amélioré au nombre d'au moins un est écrit dans la table de recherche (19), une entrée d'état de fonctionnement (21, 22, 23 ou 24) correspondante étant fournie par le détecteur au nombre d'au moins un.

6. Circuit émetteur radio selon la revendication 5, caractérisé en ce que le régulateur linéaire (18) entre une séquence d'apprentissage dans le circuit linéariseur (10), le moyen de surveillance (18) surveille le paramètre de linéarisation de la boucle réel, au nombre d'au moins un, en réponse à la séquence d'apprentissage et le moyen de sélection (18) sélectionne au moins un paramètre de linéarisation amélioré en réponse à la surveillance.

7. Circuit émetteur radio selon la revendication 6, caractérisé en ce que la séquence d'apprentissage est un mot de synchronisation utilisé pour l'apprentissage du linéariseur et pour appliquer la synchronisation au cours de transmission vers des appareils radio.

8. Circuit émetteur radio selon l'une quelconque des revendications précédentes, dans lequel le paramètre de linéarisation de la boucle au nombre d'au moins un comporte au moins l'un des éléments suivants : réglages d'amplitude, réglages de phase.

9. Emetteur-récepteur radio comprenant :
un amplificateur de puissance (12) couplé à une antenne (17) pour transmettre des signaux radio sur un canal de transmission ;
un circuit linéariseur (10) pour compenser l'absence de linéarité dans l'amplificateur de puissance (12) ;
un microprocesseur (30);
un premier circuit de contre-réaction couplé, pour fonctionner, à une sortie de l'amplificateur de puissance (12) pour alimenter une partie d'un signal radio de transmission entre la sortie de l'amplificateur de puissance (12) et le circuit linéariseur (10) pour régler le circuit linéariseur, ledit circuit linéariseur (10), ledit amplificateur de puissance (12), et ledit premier circuit de contre-réaction formant une boucle de contre-réaction en temps réel du signal radio de transmission pour maintenir la linéarité du signal radio de transmission, l'émetteur-récepteur radio étant caractérisé par :
un second circuit de contre-réaction (a ou b) couplé, pour fonctionner, à une sortie de l'amplificateur de puissance (12) pour alimenter une partie du signal radio de transmission entre la sortie de l'amplificateur de puissance (12) et un récepteur de canal adjacent (33 ou 34) pour mesurer les signaux provenant de l'amplificateur de puissance (12) qui apparaissent sur au moins un des canaux adjacents de transmission et dans lequel le microprocesseur (30) règle, de plus, le circuit linéariseur (10) en réponse à des signaux mesurés sur le canal adjacent de transmission au nombre d'au moins un.

10. Emetteur-récepteur radio selon la revendication 9, dans lequel l'émetteur-récepteur radio comporte un circuit d'émission comprenant l'amplificateur de puissance (12) couplé, pour fonctionner, au circuit linéariseur (10) par l'intermédiaire du premier circuit de contre-réaction, et couplé, pour fonctionner, au circuit linéariseur (10) par l'intermédiaire du second circuit de contre-réaction et du récepteur de canal adjacent (33 ou 34).

11. Emetteur-récepteur radio selon les revendications 9 ou 10, dans lequel l'émetteur-récepteur radio comporte un circuit émetteur comprenant :
l'amplificateur de puissance (12) couplé, pour fonctionner, au circuit linéariseur (10) par l'intermédiaire du premier circuit de contre-réaction ; et
l'émetteur-récepteur radio étant caractérisé en ce que :
un circuit récepteur bimode (34) est couplé, pour fonctionner, à une antenne (17) pour recevoir des signaux radio sur une fréquence de réception dans un premier mode de fonctionnement, et est couplé, pour fonctionner, à l'amplificateur de puissance (12) et au circuit linéariseur (10) par l'intermédiaire du second circuit de contre-réaction pour fonctionner comme récepteur de canal adjacent pour recevoir les signaux radio transmis à partir de l'amplificateur de puissance (12) sur le canal adjacent de transmission au nombre d'au moins un, dans un second mode de fonctionnement.

12. Emetteur-récepteur radio selon la revendication 11, caractérisé en outre en ce qu'un commutateur d'antenne (16) est couplé, pour fonctionner, entre une antenne (17), le circuit émetteur et le circuit récepteur bimode (34), dans lequel le fonctionnement du circuit récepteur bimode est commutable sélectivement par le commutateur d'antenne (16), entre la fréquence de réception et le canal adjacent de transmission au nombre d'au moins un, grâce au microprocesseur (30).

13. Emetteur-récepteur radio selon les revendications 11 ou 12, caractérisé en outre en ce que le microprocesseur (30) commute le fonctionnement du circuit récepteur bimode (34) entre une fréquence de réception dans une tranche de temps de réception et une fréquence de canal adjacent sur un canal de transmission et pour revenir à la fréquence de réception dans une tranche de temps de réception ultérieure.

14. Emetteur-récepteur radio selon les revendications 11, 12 ou 13, dans lequel le circuit récepteur bimode (34) est en outre caractérisé par un circuit atténuateur sélectionnable (45), commutable sur un chemin entre l'amplificateur de puissance (12) et le circuit récepteur bimode (34) pour atténuer le signal provenant de l'amplificateur de puissance (12) dans le second mode de fonctionnement et pour faire passer un signal non atténué entre l'antenne (17) et le récepteur bimode (34) au cours du second mode de fonctionnement.

15. Emetteur-récepteur radio selon l'une quelconque des revendications 9 à 14, caractérisé en outre en ce que le microprocesseur (30) sort une séquence d'apprentissage en direction du circuit linéariseur (10) et dans lequel le premier circuit de contre-réaction renvoie la séquence d'apprentissage sortie de l'amplificateur de puissance (12) au circuit linéariseur (10) afin de surveiller les paramètres de linéarisation de la boucle et renvoie la séquence d'apprentissage sortie de l'amplificateur de puissance (12) au récepteur de canal adjacent (33 ou 34) pour surveiller les signaux transmis sur le canal adjacent de transmission au nombre d'au moins un ; le microprocesseur (30) sélectionnant au moins un paramètre de linéarisation de la boucle amélioré en réponse aux paramètres de linéarisation de la boucle surveillés ou aux signaux sur le canal adjacent de transmission au nombre d'au moins un.

16. Emetteur-récepteur radio selon l'une quelconque des revendications 9 à 15, dans lequel l'émetteur-récepteur radio est caractérisé par un moyen de transmission d'une séquence de synchronisation afin de fournir des informations de synchronisation à une radio en mode réception et un moyen d'utiliser la séquence de synchronisation comme séquence d'apprentissage et l'apprentissage comme séquence de synchronisation.

17. Emetteur-récepteur radio selon l'une quelconque des revendications 9 à 16, caractérisé en outre par :
une table de recherche (19) pour mémoriser les paramètres de linéarisation de la boucle prédéterminés ; et
un régulateur (18) ayant une entrée d'état de fonctionnement, ledit régulateur (18) étant couplé à la table de recherche (19) et à la première boucle de contre-réaction pour sélectionner un paramètre de linéarisation de boucle en réponse à un signal de commande de transmission selon une entrée d'état de fonctionnement (21, 22, 23 ou 24) au régulateur (18).

18. Emetteur-récepteur radio selon la revendication 17, dans lequel l'entrée d'état de fonctionnement (21, 22, 23 ou 24) est couplée à un moyen de détection permettant de détecter au moins l'un des éléments suivants : fréquence, niveau de batterie et température, paramètres de linéarisation de la boucle comportant au moins l'un des éléments suivants : paramètres de phase de la boucle et paramètres de gain de la boucle.

19. Emetteur-récepteur radio selon la revendication 17 ou 18, dans lequel le microprocesseur (30) surveille le paramètre de linéarisation de boucle réel, choisit un paramètre de linéarisation amélioré et écrit le paramètre de linéarisation de boucle amélioré dans la table de recherche.

20. Emetteur-récepteur radio selon l'une quelconque des revendications 9 à 19, dans lequel le récepteur de canal adjacent (33 ou 34) effectue une transformation rapide de Fourrier sur le signal transmis, afin de fournir des informations de canal adjacent pour les deux canaux adjacents de transmission.
